Europäisches Patentamt

(19) European Patent Office

Office européen des brevets

(11) Numéro de publication : **0 216 697**
B1

(12) **FASCICULE DE BREVET EUROPÉEN**

(45) Date de publication du fascicule du brevet :
03.01.90

(51) Int. Cl.$^5$ : **H 03 F   3/343**, H 03 F   1/02

(21) Numéro de dépôt : 86402009.4

(22) Date de dépôt : 12.09.86

(54) Dispositif de commande d'un circuit de sortie d'un circuit intégré.

(30) Priorité : 17.09.85 FR 8513759

(43) Date de publication de la demande :
01.04.87 Bulletin 87/14

(45) Mention de la délivrance du brevet :
03.01.90 Bulletin 90/01

(84) Etats contractants·désignés :
DE FR IT NL SE

(56) Documents cités :
US–A– 4 013 940
US–A– 4 318 164
PATENTS ABSTRACTS OF JAPAN, vol. 1, no. 30,
page 1065 e 76, 29 mars 1977; & JP-A-51 122 360
(SONY K.K.) 26-10-1976

(73) Titulaire : THOMSON-CSF
51, Esplanade du Général de Gaulle
F-92800 Puteaux (FR)

(72) Inventeur : Le Roux, Gérard
Thomson-CSF SCPI 19, avenue de Messine
F-75008 Paris (FR)
Inventeur : Reffay, Marius
Thomson-CSF SCPI 19, avenue de Messine
F-75008 Paris (FR)

(74) Mandataire : Rinuy, Santarelli
14, avenue de la Grande Armée
F-75017 Paris (FR)

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

Dans le domaine des circuits intégrés, il existe souvent des circuits de sortie qui consomment une certaine puissance, par exemple, des circuits du type Darlington (voir par exemple le brevet US-A 4 013 940). La présente invention concerne un circuit de commande permettant de réduire cette consommation.

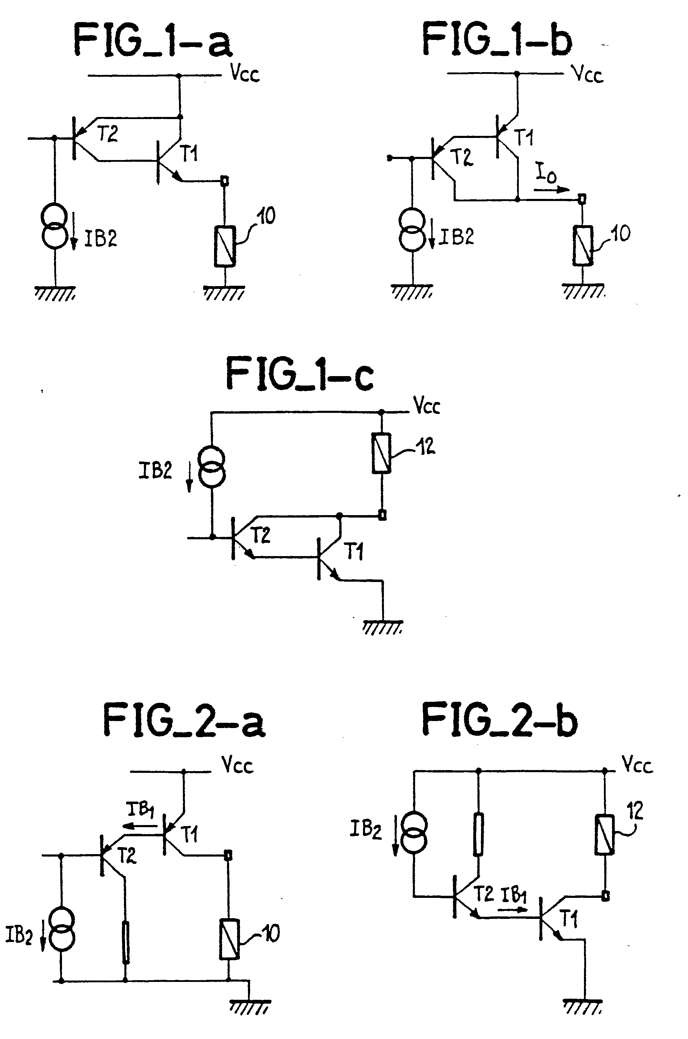

Des circuits de type Darlington sont représentés en figure 1 dans plusieurs de leurs configurations possibles. Une caractéristique générale des circuits Darlington est qu'ils comprennent au moins deux transistors bipolaires et que le gain du circuit d'ensemble est le produit des gains de chacun des transistors.

En figure 1A, le circuit Darlington est constitué d'un transistor principal T1 de type NPN et d'un transistor de commande T2 de type PNP. Le collecteur du transistor T1 est relié à la tension d'alimentation et son émetteur à la masse par l'intermédiaire d'une charge 10. La base du transistor T1 est reliée au collecteur du transistor T2 dont l'émetteur est relié à la tension d'alimentation VCC. Le signal de commande est appliqué sur la base du transistor T2 et est symbolisé par une source de courant IB2 connectée entre cette base et la masse.

En figure 1B, le circuit Darlington comprend deux transistors bipolaires de type PNP T1 et T2. L'émetteur du transistor principal T1 est relié à la tension d'alimentation VCC et le collecteur du transistor T1 à la masse par l'intermédiaire d'une charge 10. La base du transistor T1, est reliée à l'émetteur du transistor T2 de commande dont le collecteur est connecté au collecteur du transistor T1. La base du transistor T2 reçoit le signal de commande schématisé sous forme d'une source de courant IB2 connectée entre cette base et la masse.

En figure 1C, on a représenté un montage Darlington dans lequel les deux transistors sont de type NPN. Le collecteur du transistor T1 est relié au collecteur du transistor T2, ces deux collecteurs étant reliés à la tension d'alimentation VCC par l'intermédiaire d'une charge 12. L'émetteur du transistor T1 est relié à la masse et sa base à l'émetteur du transistor T2. La base du transistor T2 reçoit le signal de commande symbolisé par une source de courant IB2 connectée entre la tension d'alimentation VCC et cette base.

Ainsi, un circuit Darlington peut se définir de façon générale comme un circuit bipolaire comprenant un premier transistor principal T1 dont une première électrode principale est connectée à une borne d'alimentation VCC et une deuxième électrode principale est reliée à une borne de masse, une charge (10, 12) étant connectée entre l'une de ces électrodes principales et la borne correspondante, la base de ce premier transistor étant connectée à une deuxième électrode principale d'un second transistor, dit auxiliaire ou de commande, une électrode principale du second transistor étant reliée à une électrode principale du premier transistor et la base du second transistor recevant un signal de commande.

Pour qu'un circuit Darlington fonctionne de façon satisfaisante, que la charge soit connectée à la masse ou à la tension d'alimentation et que le transistor de sortie soit de type PNP ou NPN, il faut fournir un fort courant de base au transistor principal pour obtenir une saturation convenable. Ceci signifie que, malgré le gain du transistor auxiliaire T2, celui-ci doit recevoir un courant de base important à l'échelle des courants généralement présents dans un circuit intégré.

Si l'on examine l'expression de la puissance dissipée Pd dans ce montage Darlington elle s'exprime par la formule :

$$Pd = (VCE2 + VBE1)\ I0 + IB2 \times VCC \qquad (1)$$

— VCE2 est la tension de saturation collecteur-émetteur du transistor T2,
— VBE1 est la tension base-émetteur du transistor T1,
— I0 est le courant dans la charge,
— VCC est la tension d'alimentation du circuit,
— IB2 est le courant de base du transistor T2.

Comme on le verra ci-après, le terme IB2 × VCC est habituellement négligeable.

Pour tenter de réduire la puissance dissipée, on a parfois adopté des schémas du type de ceux représentés à la figure 2, que l'on peut appeler schémas pseudo-Darlington. Ces schémas se caractérisent par le fait que l'électrode principale du transistor de commande T2, non reliée à la base du transistor T1, n'est pas reliée à une électrode principale de ce transistor T1 mais à la masse ou à la tension d'alimentation selon le type de transistor bipolaire, par l'intermédiaire d'une résistance.

Plus particulièrement, en figure 2A, les deux transistors bipolaires du montage pseudo-Darlington sont du type PNP. L'émetteur du transistor T1 est relié à la tension d'alimentation VCC et son collecteur à la masse par l'intermédiaire d'une charge 10. La base du transistor T1 est reliée à l'émetteur du transistor T2 dont le collecteur est relié à la masse par l'intermédiaire d'une résistance. En figure 2B, les deux transistors sont de type NPN. Le collecteur du transistor T1 est relié à la tension d'alimentation VCC par l'intermédiaire d'une charge 12 et son émetteur à la masse. La base du transistor T1 est reliée à l'émetteur du transistor T2 dont le collecteur est relié à la tension d'alimentation par l'intermédiaire d'une résistance.

On voit que dans ce type de montage la puissance dissipée sera sensiblement :

$$Pd = VCE1 \times I0 + VCC \times IB1 + VCC \times IB2 \quad (2)$$

où IB1 est le courant de base du transistor T1, les autres notations étant les mêmes que précédemment, (le terme VCC × IB2 est négligeable).

Une application numérique permet de mieux comprendre le problème posé. Dans le cas des figures 1 ou 2, on a couramment I0 = 2 ampères (c'est le courant élevé que l'on cherche à faire passer dans la charge, VCC = 30 Volts, VBE1 (pour I0 = 2 ampères) de l'ordre de 1,2 V, VCE2 (pour un courant de collecteur de 50 mA) de l'ordre de 0,3 V et VCE1 = 0,8 V, pour I0 = 2 ampères.

Dans le cas de la figure 1, avec IB2 = 1 mA,

$$Pd = (0,3 + 1,2) \, 2 + 30 \times 10^{-3} = 3,03 \, W.$$

Dans le cas de la figure 2, avec IB1 = 50 mA,

$$Pd = 0,8 \times 2 + 30 \times 50 \times 10^{-3} + 30 \times 10^{-3} = 3,13 \, W.$$

Un objet de la présente invention est de prévoir un moyen de commande d'un circuit de type Darlington ou pseudo-Darlington qui permette, avec une tension d'alimentation élevée (par exemple 30 V), de réduire la puissance dissipée.

Pour atteindre cet objet ainsi que d'autres, la présente invention prévoit un dispositif de commande d'un circuit de type Darlington de sortie d'un circuit intégré comprenant deux transistors, dans lequel le premier transistor a une première électrode principale connectée à une borne d'alimentation et une deuxième électrode principale reliée à une borne de masse, une charge étant connectée entre l'une de ces électrodes principales et la borne correspondante, la base de ce premier transistor étant connectée à une deuxième électrode principale du second transistor dont la base reçoit un courant de commande. Dans ce dispositif de commande, la première électrode principale du deuxième transistor est reliée à une tension auxiliaire (V.AUX) telle que (V.AUX) soit sensiblement égale à V + VBE1 + VCE2, où VBE1 est la tension base-émetteur du premier transistor, VCE2 est la tension collecteur-émetteur du second transistor à la saturation, et V est le potentiel de la masse si la charge est connectée à la borne d'alimentation et est égal à VCC — VCE1 si la charge est connectée à la masse, VCE1 étant la tension collecteur-émetteur à la saturation du premier transistor.

La tension auxiliaire V.AUX est, selon un aspect de la présente invention, obtenue à partir de la tension d'alimentation VCC par un convertisseur continu-continu intégré dans le circuit intégré comprenant le Darlington.

Le convertisseur est de préférence un convertisseur à inductance et capacité à accumulation et à conduction discontinue de type « flyback » comprenant une inductance dont la durée de charge est commandée par un oscillateur et qui se décharge ensuite dans un condensateur.

Ces objets, caractéristiques et avantages de la présente invention seront exposés plus en détail dans la description suivante de modes de réalisation particuliers faite en relation avec les figures jointes parmi lesquelles :

les figures 1A, 1B et 1C décrites précédemment représentent des schémas de circuits Darlington de l'art antérieur ;

les figures 2A et 2B décrites précédemment représentent des schémas de circuits pseudo-Darlington de l'art antérieur ;

les figures 3A, 3B et 3C illustrent un mode de commande de circuits de type Darlington selon la présente invention ;

la figure 4 représente schématiquement, et partiellement sous forme de blocs, un circuit de convertisseur continu-continu selon la présente invention ;

la figure 5 représente schématiquement un premier mode de réalisation détaillé de la présente invention ; et

la figure 6 représente une variante améliorée de réalisation de la présente invention.

Comme on le verra plus en détail ci-après, l'idée de base de la présente invention consiste à alimenter le transistor auxiliaire ou transistor de commande T2 d'un circuit de type Darlington par une tension auxiliaire V.AUX distincte de la tension d'alimentation VCC du transistor principal T1 qui se trouve aux bornes des électrodes principales de ce transistor T1 et de la charge.

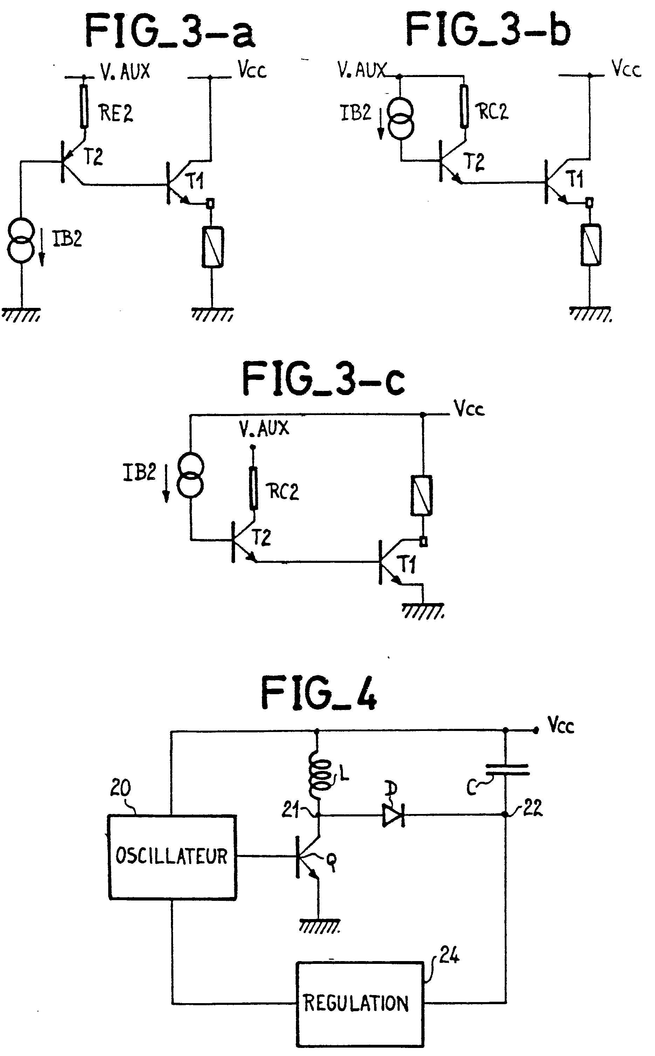

Dans la figure 3A, le circuit de type Darlington comprend un transistor principal de type NPN dont le collecteur est relié à la tension d'alimentation VCC et l'émetteur à la masse par l'intermédiaire d'une charge traversée par un courant I0. La base du transistor T1 est reliée au collecteur d'un transistor auxiliaire T2 de type PNP. L'émetteur de ce transistor T2 est relié à une tension d'alimentation auxiliaire V.AUX par l'intermédiaire d'une résistance d'émetteur RE2. Le signal de commande pour le circuit est figuré par une source de courant IB2 connectée entre la base du transistor T2 et la masse.

En figure 3B, les deux transistors sont de type NPN. Comme dans le cas de la figure 3A, le collecteur du transistor T1 est relié à la tension d'alimentation VCC et son émetteur à la masse par l'intermédiaire de la charge à alimenter. La base du transistor T1 est reliée à l'émetteur du transistor T2 dont le collecteur est relié à une tension d'alimentation auxiliaire V.AUX supérieure à VCC par l'intermédiaire d'une résistance RC2. La base du transistor T2 reçoit le signal de commande symbolisé par une source de courant IB2 connectée entre cette base et la tension auxiliaire V.AUX.

Dans le cas de la figure 3C, les deux transistors sont également de type NPN. La différence avec le schéma de la figure 3B est que la charge est connectée à la borne d'alimentation VCC, et le transistor T2 est commandé par une source de courant IB2 connectée à la tension d'alimentation VCC. En ce cas, la tension auxiliaire V.AUX est inférieure à la tension d'alimentation VCC, et est déterminée par rapport à la masse.

Ainsi, l'une des idées de base de l'invention est de prévoir une tension auxiliaire de façon à obtenir une tension supérieure à la tension d'alimentation dans le cas d'une charge connectée à la masse et supérieure à la masse dans le cas d'une charge connectée à la tension d'alimentation. La valeur de cette tension auxiliaire devra être déterminée avec soin. D'une part elle doit être suffisante pour alimenter le dispositif de commutation, d'autre part elle doit être la plus faible possible de façon à ne pas être à l'origine d'une puissance dissipée élevée. Ainsi, la tension auxiliaire doit être supérieure à la tension d'alimentation réduite de VCE1 ou à la masse selon le cas, d'une quantité de l'ordre de

VBE1 + VCE2,

VBE1 étant la tension base-émetteur du transistor T1 et du transistor T2 et VCE2 la tension collecteur-émetteur du transistor T2.

Dans le cas du montage de l'une des figures 3A, B ou C, la puissance dissipée Pd s'écrit :

$$Pd = VCE1 \times 10 + (V.AUX - VCC)$$
$$IB1 + V.AUX \times IB2, \qquad (3)$$

En reprenant les exemples numériques précédents et en choisissant V AUX — VCC = 1V, on obtient :

$$Pd = 0,8 \times 2 + 1 \times 50 \ 10^{-3} + 31 \times 10^{-3}$$
$$Pd = 1,6 + 0,05 + 0,03 = 1,7 \ W.$$

On voit que le facteur prédominant est le premier : VCE1 × I0. Ce facteur est le seul facteur prédominant alors que, dans le cas des figures 2, le facteur additionnel VCC × IB1 était loin d'être négligeable et que, dans le cas de la figure 1, la somme VCE2 + VBE1 était nettement supérieure à VCE1. Ainsi, par rapport aux cas des figures 1 et 2, avec la même tension VCC choisie à une valeur de l'ordre de 30 V, le gain en puissance dissipée est de l'ordre de 45 %.

Toutefois, si l'on veut minimiser de façon efficace la puissance dissipée, il faut maintenir à une valeur optimale aussi faible que possible la différence V.AUX — VCC qui constitue le deuxième terme de l'équation (3).

Dans ce but, selon un autre aspect de la présente invention, il est prévu de fournir cette tension auxiliaire à partir de la tension d'alimentation VCC par un convertisseur continu-continu. En plus de cet avantage de l'optimisation de la différence V.AUX, un avantage supplémentaire de la prévision d'un convertisseur continu-continu est qu'un tel dispositif peut avantageusement être intégré dans la pastille de circuit intégré comprenant le circuit de type Darlington dont on souhaite réduire la consommation. D'autre part, un convertisseur continu-continu a un rendement élevé de l'ordre de 80 %, surtout quand on le prévoit pour une fonction précise, et il n'accroit pratiquement pas la puissance dissipée par le circuit de puissance. Et la formule (3) ci-dessus est seulement affectée par la multiplication du deuxième terme par un facteur 1/R, R étant le rendement du convertisseur qui est de l'ordre de 80 %. Ainsi, le deuxième terme passe d'une valeur de 50.10⁻³ à

environ 60.10⁻³ et reste négligeable.

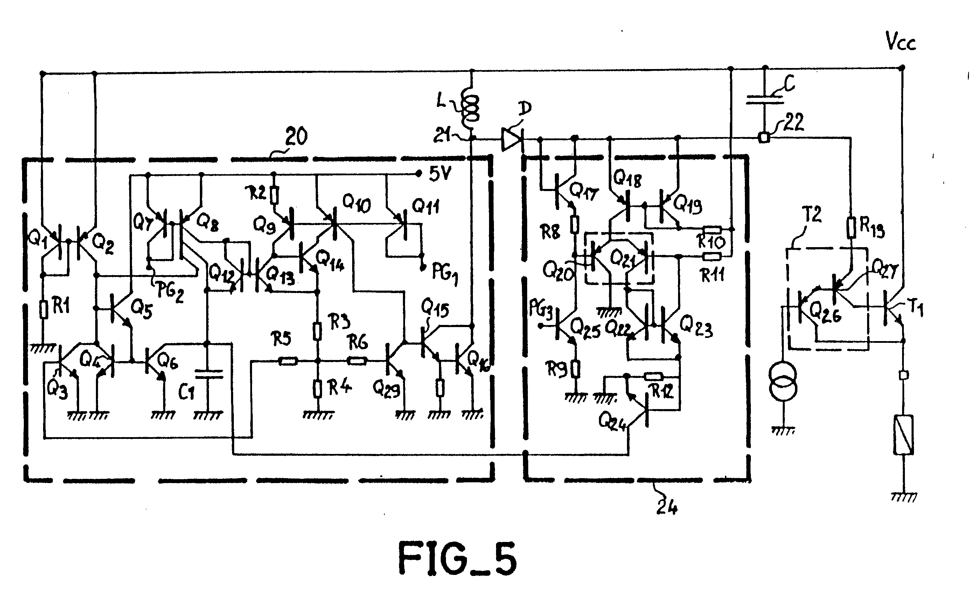

Un convertisseur continu-continu ayant un rendement particulièrement élevé et approprié à une intégration est représenté schématiquement, partiellement sous forme de blocs, en figure 4. Il comprend un oscillateur 20, alimenté par la tension VCC, qui commande la base d'un transistor de commutation Q. Dans l'exemple représenté, le transistor Q est de type NPN et a son émetteur relié à la masse et son collecteur relié à la tension d'alimentation par l'intermédiaire d'une inductance L. Le point de connexion 21 entre le collecteur et l'inductance est relié par l'intermédiaire d'une diode D à une borne de sortie 22 sur laquelle est disponible la tension auxiliaire V.AUX, un condensateur C étant relié entre cette borne 22 et la borne d'alimentation VCC. Un circuit de régulation 24 est connecté entre la borne 22 et l'oscillateur 20 pour réguler la tension auxiliaire. Ce convertisseur à inductance est un convertisseur à accumulation élévateur à conduction discontinue souvent désigné sous l'appellation anglo-saxonne « convertisseur flyback ». L'oscillateur a une période T et, dans un premier état, rend le transistor Q conducteur pendant une durée t durant laquelle l'inductance L se charge. Lorsque l'oscillateur change d'état, le transistor Q se bloque et l'inductance L se décharge dans le condensateur C par l'intermédiaire de la diode D pendant une durée t1, la période T étant telle que t + t1 est inférieur à T. La durée t1 ne dépend pas de l'oscillateur mais correspond à la durée de transfert d'énergie de l'inductance L au condensateur C. Elle dépend donc des valeurs de L et C et des résistances parasites du circuit ainsi que de la tension de seuil de la diode D, indépendamment de la valeur de VCC.

On obtient ainsi une tension auxiliaire aux bornes du condensateur C plus élevée que la tension d'alimentation. Dans ce cas, on a VAUX — VCC = VCC × t/t1. Pour que V.AUX diffère de VCC d'au moins 1 V comme on l'a expliqué précédemment, avec VCC = 30 V on choisira t/t1 sensiblement égal à 1/30.

De considérations sur le courant à fournir par cette tension auxiliaire et des lois de Lenz on tire deux autres équations qui vont déterminer le calcul de l'oscillateur :

IL max = 2I0 × T/t1, et
IL max = VCC × t/L,

où IL est le courant dans l'inductance.

Ces équations montrent que l'oscillateur doit être de période T composée d'une phase de durée proportionnelle à la valeur de VCC, t, et d'une phase résiduelle de durée supérieure à t1.

La figure 5 représente un mode de réalisation détaillé de la présente invention dans le cas où l'on utilise un convertisseur continu-continu du type de celui de la figure 4 et qu'on l'applique à un circuit de type Darlington, tel que celui illustré en figure 3A, dans lequel le transistor T1 est un transistor NPN et le transistor T2 un transistor PNP.

Plus particulièrement, en figure 5, le bloc 20 constituant l'oscillateur et le bloc 24 constituant le circuit de régulation ont été explicités.

Le bloc oscillateur 20 comprend des transistors Q1 à Q16 et un transistor Q29, des résistances R1 à R6 et un condensateur C1 de faible capacité, typiquement de quelques dizaines de pico-farads.

Les transistors Q1 et Q2 de type PNP sont montés en miroir de courant, le courant étant réglé par la résistance R1 connectée au collecteur du transistor Q1. De même, les transistors Q7 et Q8 de type PNP sont également montés en miroir de courant, leurs émetteurs étant connectés à une tension de 5 V et le collecteur du transistor Q7 à une source de courant interne PG2 du circuit. Les transistors Q9, Q10 et Q11 de type PNP sont également montés en miroir de courant, leurs émetteurs étant reliés à une tension de 5 V et leurs bases, ainsi que le collecteur du transistor Q11, à une source de courant interne PG1 du circuit. Ces transistors sont donc toujours conducteurs.

On ne donnera pas une description détaillée de toutes les connexions de ces divers transistors, celles-ci apparaissant clairement sur la figure. On décrira uniquement les connexions principales en relation avec le fonctionnement de ce circuit.

Le rythme de l'oscillateur 20 est déterminé par le cycle de charge du condensateur C1. Initialement, ce condensateur se charge sous l'effet d'un courant constant provenant des deux premiers collecteurs du transistor PNP à trois collecteurs Q8, le premier collecteur étant directement relié au condensateur C1 et le deuxième collecteur étant relié à ce condensateur par l'intermédiaire du transistor de type NPN Q12 monté en diode. Pendant ce temps, le transistor de type NPN Q13 est bloqué et le transistor de type NPN Q14 saturé. Le courant issu du transistor Q14 s'écoule vers la masse par les résistances R3 et R4 et développe sur R4 une tension suffisante pour saturer le transistor NPN Q3 monté en commutateur avec le transistor NPN Q4 qui, lui, est bloqué. Le courant issu du transistor Q2 va donc vers la masse par l'intermédiaire du transistor Q3. Tandis que le condensateur C1 se charge, la tension à ses bornes augmente et vient un moment où le potentiel sur la base du transistor Q12, c'est-à-dire également sur la base du transistor Q13 atteint une valeur supérieure à la tension aux bornes des résistances R3 et R4 d'une quantité égale à la tension de déclenchement base-émetteur VBE. Le transistor Q13 devient alors conducteur tandis que le transistor Q12 et le transistor Q14 se bloquent. Le courant dans l'ensemble R3, R4 qui passe par la résistance R2, le transistor Q9 et le transistor Q13 devient insuffisant pour que la tension aux bornes de la résistance R4 permette la conduction du transistor Q3. Ce transistor se bloque alors, le transistor Q4 devenant conducteur. Le courant dans le transistor Q2, proportionnel à VCC, additionné de la moitié du courant dans le transistor Q8, du fait de la connexion entre le collecteur du transistor Q2 et le troisième collecteur du transistor Q8 dont la surface est sensiblement moitié de la surface d'ensemble des trois collecteurs de ce transistor, s'écoule dans le transistor Q4. Le transistor Q6, dont la base est connectée à celle du transistor Q4, est rendu conducteur et décharge donc le condensateur C1 avec un courant proportionnel à la tension d'alimentation VCC. Cette décharge se poursuit jusqu'à ce que le potentiel sur la base du transistor Q13 devienne inférieur à la chute de tension dans les résistances R3 et R4 augmentée de la tension base-émetteur du transistor Q13. Le transistor Q14 conduit alors à nouveau et le cycle se répète.

On a bien obtenu un cycle de durée totale T pour l'oscillateur, la durée dans un second état (charge du condensateur C1) étant une durée t proportionnelle à la valeur de VCC, et la durée dans le premier état étant une durée t1 constante quel que soit VCC.

Le bloc 24 constituant le circuit de régulation comprend des transistors bipolaires Q17 à Q25 et des résistances R8 à R11.

Dans ce bloc, on trouve des transistors toujours conducteurs Q17, Q18, Q19 et Q25. Le transistor NPN Q17 est monté en diode, en série avec la résistance R8, le transistor Q25, également de type NPN, et la résistance R9. La base du transistor Q25 reçoit une source de courant PG3 de polarisation interne. Les transistors Q18 et Q19 de type PNP sont montés en miroir de courant, leurs émetteurs étant connectés à la tension auxiliaire (borne 22) et leurs bases étant interconnectées et également connectées au collecteur du transistor Q19 et de là, par l'intermédiaire de la résistance R10, à la tension d'alimentation VCC ; Le collecteur du transistor Q18 alimente un comparateur constitué de deux transistors PNP Q20 et Q21. La base du transistor Q20 ou première entrée du comparateur est connectée au point de raccordement de la résistance R8 et du collecteur du transistor Q25 ; et la base du transistor Q21 ou deuxième entrée du comparateur est connectée à la tension d'alimentation VCC par l'intermédiaire de la résistance R11. Ainsi, le comparateur compare la tension auxiliaire V.AUX diminuée de la chute de tension dans la diode Q17 et dans la résistance R8 avec la tension d'alimentation VCC. Dès que la tension VCC devient inférieure à l'autre terme de la comparaison, le transistor Q21 devient conducteur et un courant circule par le transistor NPN Q22 monté en diode vers la base du transistor de type NPN Q24, monté en parallèle avec le condensateur C1 rendant ce transistor Q24 conducteur, ce qui court-circuite le condensateur C1 de l'oscillateur 20 et bloque cet oscillateur. Ainsi, on stabilise le système à un fonctionnement tel que :

$$V.AUX = VCC + VBE17 + R8 \times I25,$$

où I25 est le courant dans le transistor Q25 et donc dans la résistance R8.

On notera la connexion particulière des transistors Q22 et Q23 qui est destinée à assurer une légère hystérésis de façon à éviter un fonctionnement erratique.

A part l'explicitation de l'oscillateur 20 et du circuit de régulation 24, le schéma de la figure 5 est par ailleurs similaire à celui de la figure 4. On notera toutefois, que le transistor T2, au lieu d'être constitué par un transistor unique, est remplacé par deux transistors Q26 et Q27 eux-mêmes montés en Darlington avec une résistance R13 sur l'émetteur du transistor Q27, cette résistance étant équivalente à la résistance RE2 représentée en figure 3A.

On prévoiera également, en pratique, d'autres résistances destinées à sécuriser le fonctionnement du circuit et notamment une résistance de fuite disposée entre la base de l'émetteur du transistor T1.

A titre de variante de la présente invention, et pour améliorer le réglage exact de la tension auxiliaire, c'est-à-dire en définitive le courant de base dans le transistor T1, on peut prévoir d'ajouter au circuit précédemment décrit en relation avec la figure 5 des moyens utilisant une détection du courant dans le transistor T1.

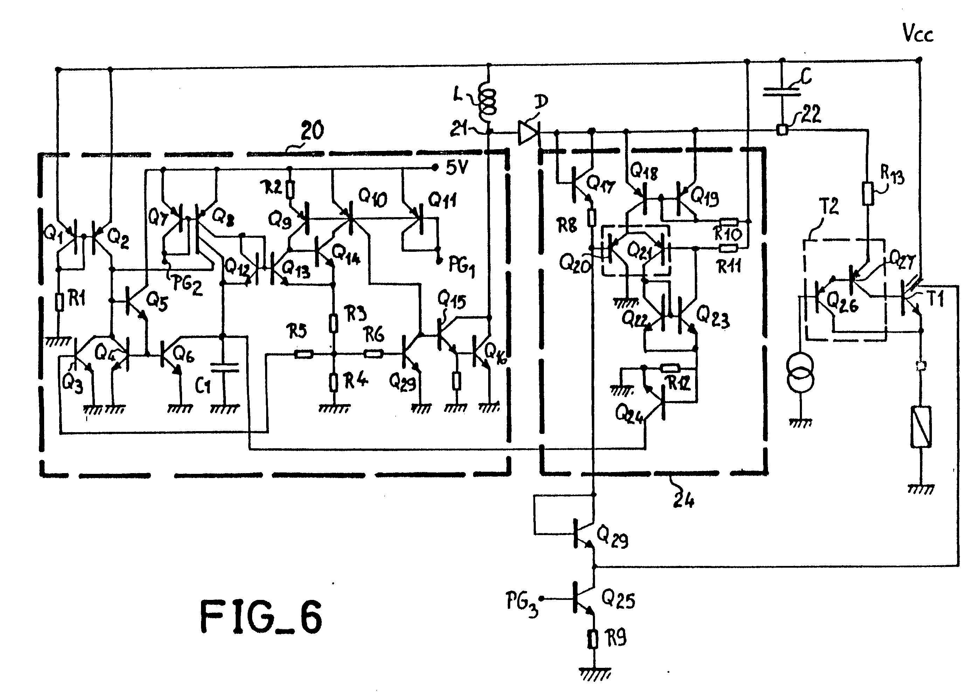

Cette variante est représentée en figure 6. Le transistor T1 est modifié. Dans ce transistor, de type NPN, on réalise une diffusion P supplémentaire en même temps que la diffusion de base et à proximité de celle-ci. Il est ainsi formé un transistor PNP supplémentaire dont l'émetteur correspond à la base du transistor T1, la base correspond au collecteur du transistor T1 et l'émetteur est la diffusion P supplémentaire. Lorsque le transistor T1 s'approche d'un régime de saturation, le potentiel de sa base devient supérieur à celui de son collecteur. Ainsi, la jonction base-émetteur du transistor PNP supplémentaire est polarisée dans le sens direct ; il y a alors émission de porteurs dont une partie peut être collectée par la diffusion P supplémentaire. Ce transistor supplémentaire permet donc de fournir un signal indicatif du fait que le transistor T1 entre en saturation.

Ce signal indicatif va être utilisé en relation avec le comparateur Q20-Q21 précédemment décrit pour mieux régler la tension auxiliaire V.AUX. Dans ce but, à la connexion série comprenant la diode Q17, la résistance R8, le transistor Q25 et la résistance R9, on ajoute entre la connexion de la résistance R8 à la base du transistor Q20 et le collecteur du transistor Q25 une diode Q29. Le point de raccordement entre cette diode Q29 et le collecteur du transistor Q25 est relié au collecteur du transistor PNP auxiliaire. Le courant collecté par le collecteur du transistor auxiliaire va s'écouler dans la source de courant constituée par le transistor Q25. Ainsi, le courant, précédemment appelé I25 passant dans la résistance R8 va être réduit puisque le courant total dans le transistor Q25 reste constant. C'est-à-dire que le premier terme de comparaison précédemment exposé pour le comparateur Q20-Q21 qui est VBE17 + R8 × I25 va diminuer dès que le transistor T1 rentrera en saturation. En réglant de façon appropriée la dimension et la forme de la diffusion de type P constituée dans le collecteur du transistor supplémentaire par rapport à la valeur du courant imposé par le transistor Q25 et par rapport à la valeur de R8, on peut obtenir une tension auxiliaire adaptée, selon que le transistor T1 est en saturation ou non, pour que le transistor T1 soit toujours à la limite de la saturation, c'est-à-dire à l'état où il consomme le moins.

La diode Q29 est destinée à éviter que le collecteur du transistor supplémentaire superposé au transistor T1 ne puisse atteindre transitoirement un potentiel plus élevé que la tension d'alimentation VCC ce qui induirait une conduction en inverse de ce transistor.

## Revendications

1. Dispositif de commande d'un circuit de type Darlington de sortie d'un circuit intégré comprenant deux transistors dans lequel le premier transistor (T1) a une première électrode principale connectée à une borne d'alimentation (VCC) et une deuxième électrode principale reliée à une borne de masse, une charge étant connectée entre l'une de ces électrodes principales et la borne correspondante, la base de ce premier transistor étant connectée à une deuxième électrode principale du second transistor (T2) dont la base reçoit un courant de commande, caractérisé en ce que la première électrode principale du deuxième transistor est reliée à une tension auxiliaire (V.AUX) telle que (V.AUX) soit sensiblement égale à V + VBE1 + VCE2, où :

VBE1 est la tension base-émetteur du premier transistor,

VCE2 est la tension collecteur-émetteur du second transistor à la saturation, et

V est le potentiel de la masse si la charge est connectée à la borne d'alimentation et est égal à VCC — VCE1 si la charge est connectée à la masse, VCE1 étant la tension collecteur-émetteur à la saturation du premier transistor.

2. Dispositif selon la revendication 1, caractérisé en ce que la tension auxiliaire (V.AUX) est obtenue à partir de la tension d'alimentation (VCC) par un convertisseur continu-continu intégré dans le circuit intégré comprenant le Darlington.

3. Dispositif selon la revendication 2, caractérisé en ce que le convertisseur est un convertisseur à inductance et capacité à accumulation et à conduction discontinue de type « flyback » comprenant une inductance dont la durée de charge (t) puis de décharge (t1) dans un condensateur (C) est commandée par un oscillateur (20).

4. Dispositif selon la revendication 3 dans lequel la période de l'oscillateur comprend un premier état et un deuxième état, caractérisé en ce que la durée (t) du premier état dépend de la valeur de la tension d'alimentation (VCC).

5. Dispositif selon la revendication 3, caractérisé en ce qu'il comprend en outre un circuit de régulation pour interrompre le fonctionnement de l'oscillateur quand la tension auxiliaire s'écarte de la valeur choisie.

6. Dispositif selon la revendication 4, caractérisé en ce que la durée du premier état est assurée par la durée de charge, par une tension liée à la valeur VCC, d'un condensateur intégré (C1) de faible valeur.

7. Dispositif selon la revendication 4, caractérisé en ce que la régulation est assurée par une détection de saturation du transistor principal du circuit Darlington.

## Claims

1. Device for controlling an integrated circuit Darlington type output circuit comprising two transistors in which the first transistor (T1) has a first main electrode connected to a supply terminal (VCC) and a second main electrode connected to an earth terminal, a load being connected between one of these main electrodes and the corresponding terminal, the base of the first transistor being connected to a second main electrode of the second transistor (T2) the base of which receives a control current, characterised in that the first main electrode of the second transistor is connected to an auxiliary voltage (V.AUX) such that (V.AUX) is substantially equal to V + VBE1 + VCE2 where :

VBE1 is the base-emitter voltage of the first transistor,

VCE2 is the collector-emitter voltage of the second transistor when it is saturated, and

V is equal to the earth potential if the load is connected to the supply terminal and is equal to VCC — VCE1 if the load is connected to the earth terminal, VCE1 being the collector-emitter voltage of the first transistor when it is saturated.

2. Device according to claim 1 characterised in that the auxiliary voltage (V.AUX) is derived from the supply voltage (VCC) by a DC-DC converter integrated into the integrated circuit comprising the Darlington circuit.

3. Device according to claim 2 characterised in that the converter is an inductance-capacitance accumulator/discontinuous conduction « flyback » type converter comprising an inductor with the time (t) to charge and the time (t1) to discharge a capacitor (C) controlled by an oscillator (20).

4. Device according to claim 3 wherein the period of the oscillator comprises a first state and a second state characterised in that the duration (t) of the first state depends on the value of the supply voltage (VCC).

5. Device according to claim 3 characterised in that it further comprises a regulator circuit for interrupting the operation of the oscillator when the auxiliary voltage departs from the chosen value.

6. Device according to claim 4 characterised in that the duration of the first state is determined by the time to charge an integrated low-value capacitor (C1) to a voltage related to the value VCC.

7. Device according to claim 4 characterised in that regulation is obtained by detecting saturation of the main transistor of the Darlington circuit.

## Patentansprüche

1. Steuervorrichtung für eine Darlington-Ausgangsstufe einer integrierten Schaltung, die zwei Transistoren aufweist und in der der erste Transistor (T1) eine erste Hauptelektrode, die mit einem Versorgungsanschluß (VCC) verbunden ist, und eine zweite Hauptelektrode umfaßt, die mit einem Masseanschluß verbunden ist, wobei zwischen die eine dieser Hauptelektroden und den zugehörigen Anschluß eine Last eingeschaltet und die Basis dieses ersten Transistors mit einer zweiten Hauptelektrode des zweiten Transistors (T2) verbunden ist, dessen Basis einen Steuerstrom empfängt,
dadurch gekennzeichnet, daß die erste Hauptelektrode des zweiten Transistors mit einer Hilfsspannung (V.AUX) so verbunden ist, daß die Hilfsspannung (V.AUX) im wesentlichen gleich V + VBE1 + VCE2 ist, wobei

VBE1 die Basis-Emitterspannung des ersten Transistors,

VCE2 die Kollektor-Emitterspannung des zweiten Transistors bei Sättigung und

V dann, wenn die Last mit dem Versorgungsanschluß verbunden ist, das Massepotential und dann, wenn die Last mit der Masse verbunden ist, gleich VCC — VCE1 ist, wobei VCE1 die Kollektor-Emitterspannung bei Sättigung des ersten Transistors ist.

2. Steuervorrichtung nach Anspruch 1, dadurch gekennzeichnet, daß die Hilfsspannung (V.AUX) ausgehend von der Versorgungsspannung (VCC) mit Hilfe eines Gleichspannungsumformers erhalten wird, der in die integrierte Schaltung, welche die Darlington-Stufe umfaßt, integriert ist.

3. Steuervorrichtung nach Anspruch 2, dadurch gekennzeichnet, daß der Umformer ein Induktanz-Kapazitäts-Umformer mit Speicherung und diskontinuierlicher Leistung vom Flyback-Typ ist, der eine Induktivität umfaßt, deren Ladezeit (t) und deren folgende Entladezeit (t1) in einen Kondensator (C) von einem Oszillator (20) gesteuert werden.

4. Steuervorrichtung nach Anspruch 3, bei der die Periode des Oszillators einen ersten und einen zweiten Zustand umfaßt, dadurch gekennzeichnet, daß die Dauer (t) des ersten Zustandes vom Wert der Versorgungsspannung (VCC) abhängt.

5. Steuervorrichtung nach Anspruch 3, dadurch gekennzeichnet, daß sie im übrigen eine Regelschaltung umfaßt, die dazu dient, das Arbeiten des Oszillators dann zu unterbrechen, wenn die Hilfsspannung vom gewählten Wert abweicht.

6. Steuervorrichtung nach Anspruch 4, dadurch gekennzeichnet, daß die Dauer des ersten Zustandes vermittels einer mit dem Wert VCC verbundenen Spannung durch die Ladezeit eines einen kleinen Wert besitzenden integrierten Kondensators (C1) sichergestellt wird.

7. Steuervorrichtung nach Anspruch 4, dadurch gekennzeichnet, daß die Regelung durch eine Detektion der Sättigung des Haupttransistors der Darlington-Schaltung sichergestellt wird.

# FIG_1-a

# FIG_1-b

# FIG_1-c

# FIG_2-a

# FIG_2-b

FIG_3-a

FIG_3-b

FIG_3-c

FIG_4

FIG_5

EP 0 216 697 B1

FIG_6

EP 0 216 697 B1